# EUROPEAN PATENT APPLICATION

(11) **EP 4 793 222 A1**
(43) Date of publication of application: **19.08.2026**
(21) Application number: 25158186.4
(22) Date of filing: 17.02.2025
(51) Int. Cl.: B81B 7/00

(54) **A MICROELECTROMECHANICAL DEVICE AND A METHOD**

(71) Applicant: Murata Manufacturing Co., Ltd., Nagaokakyo-shi, Kyoto 617-8555 (JP)
(72) Inventor: IIHOLA, Antti, 00950 Helsinki (FI); TORKKELI, Altti, 04340 Tuusula (FI)
(74) Representative: Boco IP Oy Ab

(57) **Abstract**

A microelectromechanical device comprises a MEMS device layer a handle layer and a cap layer. The device also comprises an interposer layer between the handle layer and the MEMS device layer. The interposer layer comprises an insulating layer on the surface of the handle layer and a polysilicon layer on the insulating layer. The device layer comprises a mobile mass element. The polysilicon layer lies beneath the mass element and is electrically connected to a first external contact in the cap layer through the device layer.

## Description

### FIELD OF THE DISCLOSURE

This disclosure relates to microelectromechanical (MEMS) device, and particularly to measurement arrangements in such devices. The present disclosure further concerns the transfer of measurement signals from the inside of a MEMS device to the outside.

### BACKGROUND OF THE DISCLOSURE

MEMS devices are typically manufactured in processes where layers are stacked on top of each other. Some of these layers may be preprocessed wafers which are bonded to each other in the manufacturing process. Other layers may be formed by depositing materials on these wafers. Wafers may be diced into chips when the assembly has been completed. Hundreds or thousands of individual chips may be formed from one wafer stack.

At least some MEMS device elements are typically formed in a central layer which may be called the device layer. These devices elements may include movable mass elements. The mass elements may be suspended from adjacent fixed structures by flexible suspenders which are also formed in the device layer. When the masses are influenced by an external force, their movement can be measured, and the direction and magnitude of the external force may be deduced from this measurement.

The device layer may be flanked on one side by a handle layer, which gives the device layer structural support, and on the other side by a cap layer. Other intermediate layers may also be present, but the handle layer and the cap layer typically seal the MEMS device elements inside an enclosure.

The motion of a mass element may be measured capacitively. The mass element itself may function as one of the electrodes in the capacitor if it is formed from doped silicon. A counterelectrode may be built somewhere within the enclosure adjacent to the mass element.

In some applications, the motion of the mass needs to be measured in a direction which is perpendicular to the device layer. This direction may be called the z-direction. One way to measure movement in the z-direction is to place the counterelectrode on the handle layer or on the cap layer, so that it is adjacent to the mass element and separated from the mass element by a gap in the z-direction. Document US2024103035 discloses a MEMS device with such measurement arrangements.

However, a general challenge in this arrangement for measuring movement in the z-direction is that the relationship between mass displacement and capacitance change can be nonlinear. If the actual height of the gap in the finished chip does not correspond very closely to the intended height (due inaccuracies in the manufacturing process), then the measurement can become inaccurate. The nonlinearity of the response can also make it difficult to reliably compensate for an inaccurate gap through calibration.

### BRIEF DESCRIPTION OF THE DISCLOSURE

An object of the present disclosure is to provide a method for forming accurate measurement gaps, and a MEMS device with an accurate gap.

The object of the disclosure is achieved by a method and an arrangement which are characterized by what is stated in the independent claims. The preferred embodiments of the disclosure are disclosed in the dependent claims. The disclosure is based on the idea of utilizing oxide layers for accurate gap determination.

### BRIEF DESCRIPTION OF THE DRAWINGS

In the following the disclosure will be described in greater detail by means of preferred embodiments with reference to the accompanying drawings, in which
Figures 1a - 1b illustrate a microelectromechanical device.
Figures 2a - 2i illustrate a process for manufacturing a microelectromechanical device.
Figures 3a - 3c illustrate a first additional embodiment.
Figures 4a - 4c illustrate a second additional embodiment.
Figures 5a - 5b illustrate a third additional embodiment.

The figures have not been drawn to scale.

### DETAILED DESCRIPTION OF THE DISCLOSURE

This disclosure describes a microelectromechanical device. The device comprises a MEMS device layer which defines an xy-plane. A z-direction is perpendicular to the xy-plane.

The MEMS device layer is made of silicon. The MEMS device layer comprises a first measurement region and a via region, and the first measurement region is electrically separated from the via region.

The device also comprises a handle layer. The handle layer has a surface which faces toward the MEMS device layer. The device also comprises a cap layer. The handle layer and cap layer are on opposite sides of the MEMS device layer.

The microelectromechanical device also comprises an interposer layer between the handle layer and the MEMS device layer. The interposer layer comprises an insulating layer on the surface of the handle layer and a polysilicon layer on the insulating layer.

The polysilicon layer comprises an electrode region which is adjacent to the first measurement region of the MEMS device layer. The electrode region of the polysilicon layer is separated from the first measurement region of the MEMS device layer by a first gap.

The polysilicon layer also comprises an interconnection region which extends from the electrode region to the via region of the MEMS device layer. The electrode region of the polysilicon layer is in electrical contact with the via region of the MEMS device layer. The via region of the MEMS device layer is electrically connected to a first external contact in the cap layer.

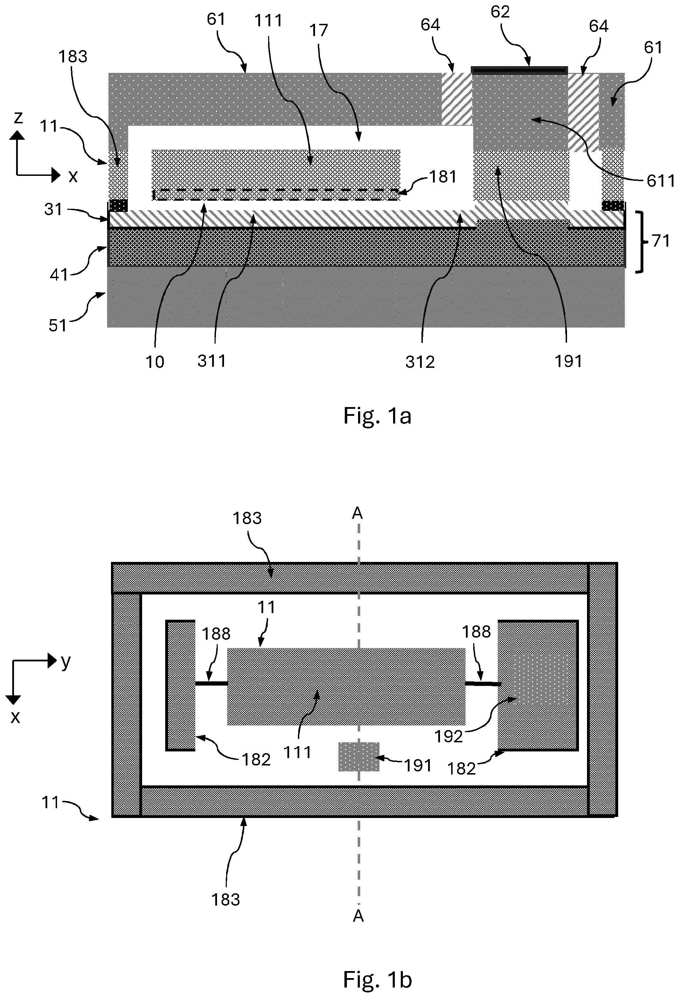

Figure 1a illustrates the layers in the microelectromechanical device with a MEMS device layer 11. The device plane may be illustrated as the xy-plane, and in this case figure 1a shows an xz-cross-section of the device. The device plane is determined by the device layer. The device layer may be formed by a silicon wafer, which may be called the device wafer or structure wafer. Alternatively, the device layer may be a silicon layer which has been deposited on an underlying substrate. The silicon may be doped, and the device layer 11 may in practice be electrically conductive.

The MEMS device layer 11 comprises a micromechanical structure in the first measurement region 181. This structure may for example be an entire mobile mass element 111, or a part of a mobile mass element 111. The first measurement region 181 may for example be defined by the bottom surface of the mass element 111, as figure 1a illustrates, or by a part of that bottom surface. The MEMS device layer 11 may also comprise fixed parts such as a first fixed structure 182. The fixed parts of the device layer may remain immobile in relation to the surrounding fixed structures (such as the handle layer and the cap layer) when the device is in use.

The mobile mass element 111 where the first measurement region 181 is located may be suspended from adjacent fixed parts by a flexible suspension structure (not illustrated). The suspension structure may allow the mass element 111 to move with respect to the fixed structures of the device when a force acts upon it.

In particular, the suspension structure may allow the mass element 111 to move in the z-direction, out of the device plane. The mass element 111 may for example be configured to rotate about a rotation axis which lies in the device plane, so that the first measurement region 181 moves in the z-direction. Alternatively, the suspension structure may be configured to allow the entire mass element 111 to be moved in linear translation in the z-direction.

The MEMS device layer 11 also comprises a via region 191. The via region 191 is a fixed part of the device layer 11. An electrical signal can be transmitted through the device layer 11 in the z-direction in the via region 191, as explained below. The via region 191 is electrically separated from the first measurement region 181. This electrical separation may for example be created by separating the two regions mechanically from each other when the device layer 11 is etched, as explained below.

Figure 1a also illustrates a handle layer 51 and an interposer layer 71. The interposer layer comprises many sublayers. One of these sublayers may be an insulating layer 41. Another sublayer may be a polysilicon layer 31. The polysilicon layer 31 is electrically conductive.

The polysilicon layer 31 comprises an electrode region 311 which faces the first measurement region 181 of the device layer 11. They are separated by a first gap 10. The polysilicon layer 31 and the mass element 111 form a first capacitor across the first gap 10. The first measurement region 181 and the electrode region 311 function as electrodes in a capacitive measurement where the movement of the mass element 111 in the z-direction is detected.

The height of the first gap in the z-direction may be in the range 1 - 3 micrometers, or preferably in the range 1.4 - 2.4 micrometers.

The polysilicon layer 31 also has an interconnection region 312 which extends beyond the first measurement region 181 of the device layer 11. The interconnection region 312 extends to the via region 191 of the device layer 11.

The device also comprises a cap layer 61. The cap layer 61 and the interposer layer 71 may form a sealed enclosure 17 around the mobile mass element 111. The cap layer 61 may comprise a first external contact 62, which may for example be located on the top surface of the cap layer, as figure 1a illustrates. Other options are also possible. The cap layer 61 may be made of silicon, and it may be doped so that it is electrically conductive. The cap layer 61 may comprise a first vertical contact 611 which extends from the via region 191 of the MEMS device layer to the first external contact 62.

A first electrical signal may be retrieved from the electrode region 311 via the via region 191, the first vertical contact 611 and the first external contact 62. Alternatively, the first vertical contact 611 could itself also be used as the first external contact. The first vertical contact 611 and the first external contact 62 may be electrically isolated from other parts of the cap layer 61 by insulating cap regions 64.

In general, the device layer may comprise a mobile mass element 111. The polysilicon layer 31 may lie beneath the mass element 11. The polysilicon layer 31 may be electrically connected to the first external contact 62 in the cap layer 61 through the device layer 11.

A second electrical signal may be retrieved from the mass element 111 via its suspenders. Figure 1b illustrates this schematically in the xy-plane, where the mass element 111 is suspended from the first fixed structure 182 with suspenders 188. The mass element 111 and the first fixed structure 182 may be at the same electric potential since the suspenders 188 connect them to each other. All of these elements may be formed in the device layer 11.

The first fixed structure 182 may be connected to an external contact in the cap layer 61 in region 192. Figure 1a illustrates the xz-cross-section along the line A-A in figure 1b. Reference number 183 indicates a second fixed part of the device layer 11, which may be on the edge of the chip. The second fixed part 183, the via region 191 and the first fixed structure 182 may all be electrically separated from each other.

The microelectromechanical device may be a gyroscope. Alternatively, the microelectromechanical device may be an accelerometer. Another alternative is that the device is both a gyroscope and an accelerometer.

A corresponding method for manufacturing a microelectromechanical device may comprise providing a MEMS device layer 11, wherein the MEMS device layer 11 is made of silicon, and the MEMS device layer 11 comprises a first measurement region 181 and a via region 191. The method may also comprise providing a handle layer 51 and a cap layer 61, where the cap layer 61 comprises a first external contact 62.

The method may also comprise forming an oxide layer 21 on a first side of the MEMS device layer 11 and forming an opening in the oxide layer in the via region of the MEMS device layer 11. The method may also comprise depositing a polysilicon layer 31 on the oxide layer at least in the first measurement region 181 and the via region 191 of the MEMS device layer 11, so that the polysilicon layer 31 comes into contact with the MEMS device layer 11 through the opening in the via region 191.

The method may also comprise forming an insulating layer 41 on the polysilicon layer 31 and bonding the handle layer 51 to the insulating layer 41. The method may also comprise removing the oxide layer at least from the first measurement region 181 of the MEMS device layer 11 and bonding the cap layer 61 to a second side of the MEMS device layer 11 so that the first external contact 62 in the cap layer 61 comes into electrical contact with the via region 191 of the MEMS device layer 11. The second side of the MEMS device layer is opposite to the first.

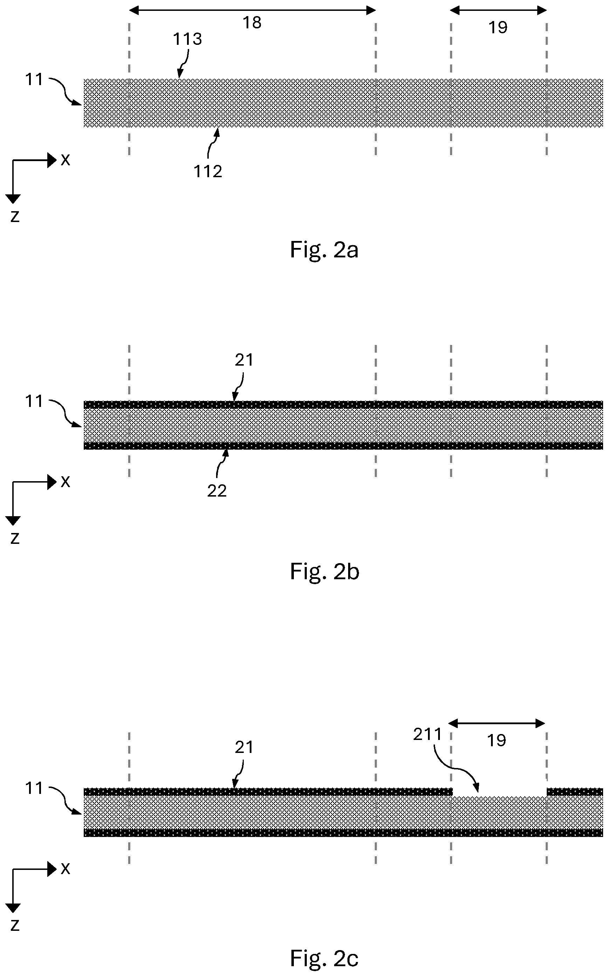

Figures 2a - 2i illustrate the method in detail. Figure 2a shows a MEMS device layer 11 with a first side 113 and 112. The device layer 11 may at this stage be hundreds of micrometers thick in the z-direction, and it may be thinned later. Alternatively, the device layer 11 may have its final thickness at this stage, and it may be supported by a temporary substrate (not illustrated). The device layer 11 may for example have been deposited on the substrate. The thickness of the device layer may in the latter case, and in the former case after thinning, for example be in the range 20 - 150 micrometers, or, more preferably, in the range 40 - 100 micrometers.

A first region 18 on the device layer 11 is the area where the first measurement region 181 will eventually be formed. A second region 19 is the area where the via region 191 will be formed. In any embodiment presented in this disclosure, the MEMS device layer 11 may be made of crystalline silicon or polycrystalline silicon. Crystalline silicon may also be called single-crystal silicon.

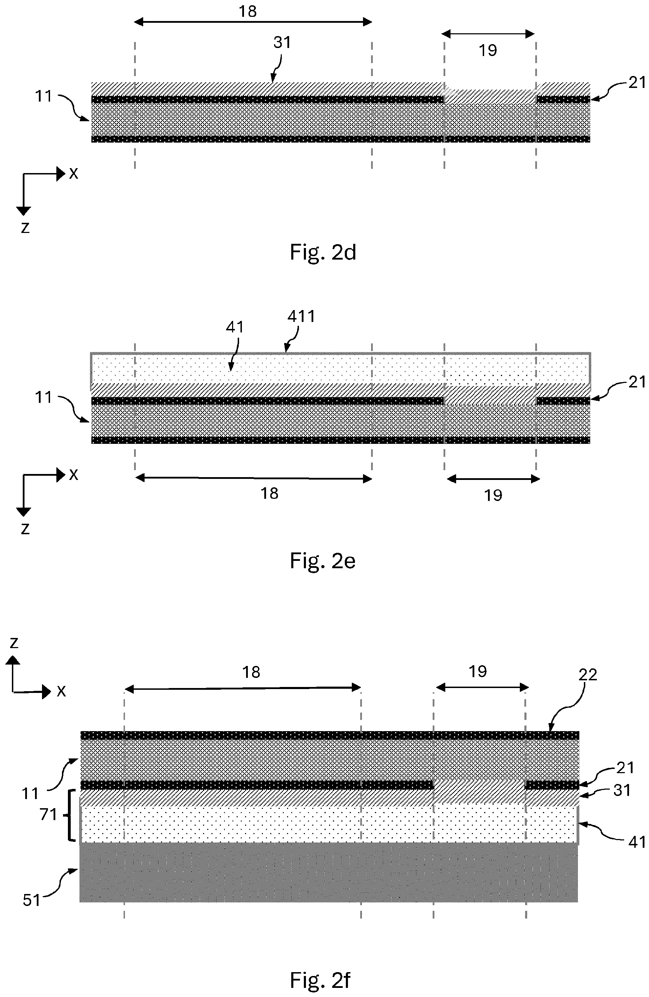

Thermal oxidation is performed on the MEMS device layer 11 to form the oxide layer 21, which is a layer of silicon dioxide, on the surface of the device layer 11 on the first side 113. This is illustrated in figure 2b. Optionally, if the MEMS device layer 11 is a silicon wafer, another silicon dioxide layer 22 may at the same time be formed on the surface of the device layer 11 on second side 112. However, if the MEMS device layer 11 has been deposited onto a temporary substrate (not illustrated) which can be removed in figure 2f, then no oxide layer is formed on the second side 112.

The thickness of the oxide layer 21 in the z-direction can be controlled very accurately since the oxidation rate of a silicon wafer in thermal oxidation is well known. As explained below, the oxide layer 21 will later be removed, and the height of this layer will determine height of the first gap 10. The arithmetic mean roughness of the top surface of the oxide layer 21 in figure 2b may be less than 10 nanometers or less than 5 nanometres. The difference between the highest peak and the lowest valley may be less than 40 nanometres, less than 20 nanometres or less than 10 nanometers.

The oxide layer 21 may be patterned by lithography and dry etching to form an opening 211 in the second region 19, as figure 2c illustrates. Alternatively, wet etching can be used. The polysilicon layer 31 may then be deposited on the oxide layer 21, as figure 2d illustrates, for example by low pressure chemical vapour deposition. The thickness of the polysilicon layer 31 in the z-direction may for example be in the range 50 - 400 nm in any embodiment presented in this disclosure.

The arithmetic mean roughness of the top surface of the polysilicon layer 31 in figure 2d in the first region 18 may be less than 10 nanometers or less than 5 nanometres. The difference between the highest peak and the lowest valley in the polysilicon layer 31 in the first region 18 may be less than 40 nanometres, less than 20 nanometres or less than 10 nanometers.

Due to the opening 211, the polysilicon layer 31 comes into direct contact with the device layer 11 in the second region 19. The polysilicon layer 31 may be doped, for example with boron or phosphorus, so that it is electrically conductive. The part of the polysilicon layer 31 which lies in the first region 18 will eventually form the electrode region 311 of the polysilicon layer 31, while the part of the polysilicon layer 31 which lies in the second region 19, and between the first and second regions 18 and 19, will form the interconnection region 312 of the polysilicon layer 31.

The insulating layer 41 is then formed on the polysilicon layer 31, as figure 2e illustrates. This layer may for example be made of silicon dioxide. It may be deposited by plasma-enhanced chemical vapour deposition. The thickness of the insulating layer 41 in the z-direction may for example be at least 10 times greater than the thickness of the polysilicon layer 31. The thickness of the insulating layer 41 may for example be in the range 2-10 micrometers, or in the range 4-8 micrometers. The top surface 411 of the insulating layer 41 in figure 2e may be polished, for example by chemical-mechanical polishing, to make the surface flat.

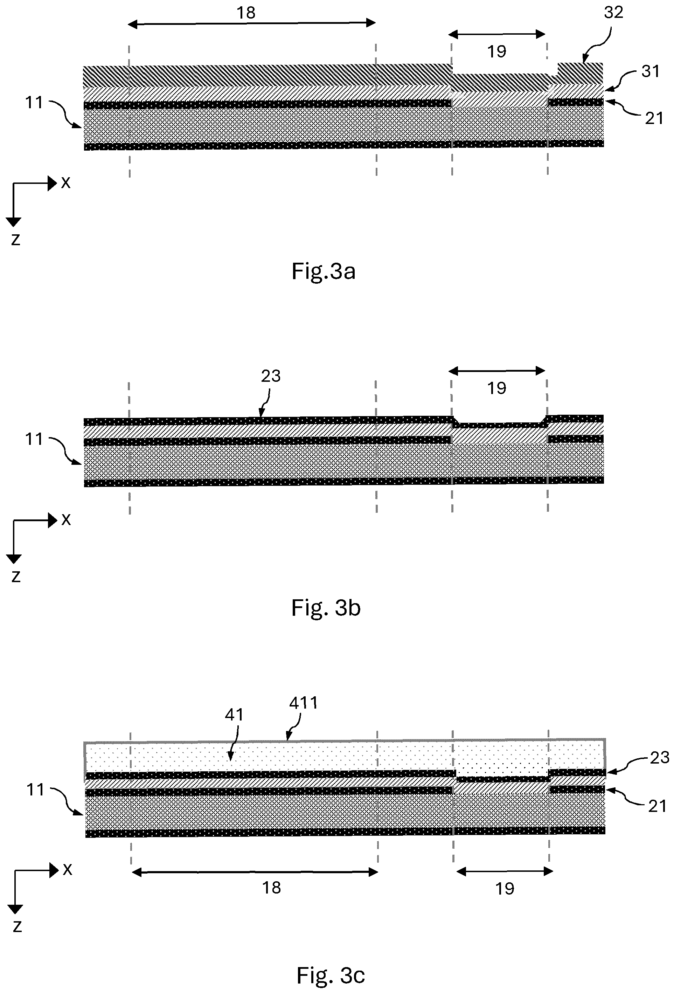

The polysilicon layer 31 is in the figures of this disclosure shown as a simple layer which extends from left to right, but it may in practice be patterned in figure 2d so that it is present only in selected regions of the xy-plane where electrical conductivity is needed. In any region of the xy-plane where polysilicon layer 31 is removed, the insulating layer 41 will be in direct contact with oxide layer 21 (or, with reference to the first additional embodiment showed in figure 3c, the additional oxide layer 23 may be in direct contact with oxide layer 21).

The arrangement is then flipped around, as figure 2f illustrates, and the top surface 411 of the insulating layer 41 is bonded to the handle layer 51, for example in a fusion bonding process. All parts of the interposer layer 71 now lie between the device layer 11 and the handle layer 51. The handle layer 51 may be a silicon wafer. The handle layer 51 may be several hundred micrometers thick in the z-direction. If necessary, the device layer 11 may at this stage be made thinner for example by grinding and chemical-mechanical polishing. The final thickness of the device layer 11 in the z-direction after thinning may for example be in the range 50 - 150 micrometers.

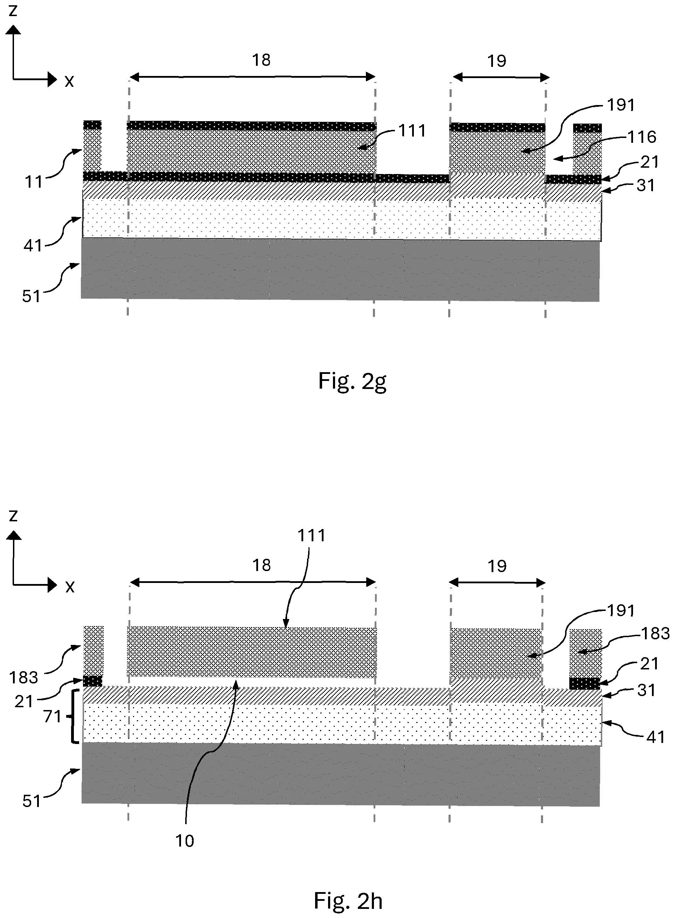

The device layer 11 is patterned in figure 2g (by lithography and etching) to form the mass element 111, the via region 191 and other microstructures, such as the first fixed structure 182 and the suspenders 188 illustrated in figure 1b. This patterning thereby forms the micromechanical structures which will eventually be mechanically and electrically active. It separates some of these structures electrically from each other. The via region 191 may be separated from other parts of device layer 11 by an isolation trench 116.

The MEMS device layer 11 may be perforated in the z-direction. The perforations (not illustrated in the figures) are a set of relatively small holes which extend through the device layer 11 in the z-direction. They facilitate easier access to the bottom of the device layer 11 when the oxide layer 21 is removed (see figure 2h). Perforations may be etched in the first measurement region in the device layer 11, but they may alternatively be located elsewhere. The optimal locations and sizes of the perforations depend on the geometry of the device, on the thickness of the oxide layer 21 and how much undercut is allowed in the oxide 21 or in the insulating layer 41 outside the region 18. The undercut outside the region 18 is not illustrated.

Figure 2h illustrates the step where the oxide layer 21 is removed. It may for example be removed with HF vapour or by wet etching. The removal of the oxide layer releases the mass element 111 and its suspenders from the underlying interposer layer 71. Consequently, the mass element 111 can now move with respect to the fixed structures of the device. The first gap 10 has been formed between the polysilicon layer 31 and the mass element 111. The via region 191 remains fixed.

The oxide layer 21 is not removed everywhere beneath the device layer 11. Many fixed parts of the device layer 11 will remain fixed to the underlying interposer layer 71 by the oxide layer 21. This is schematically illustrated in figure 2h, where the oxide layer 21 still remains underneath the second fixed part 183 and anchors them to the interposer layer 71. In practice, the oxide layer 21 may lie underneath the entire first fixed structure 182 and underneath the entire second fixed part 183 in figure 1b to keep them fixed to the underlying handle layer. The via region 191 of the device layer 11 is anchored to the handle layer by polysilicon layer 31.

Referring back to the discussion on figure 2b, if the device layer 11 was originally deposited on a sacrificial substrate (not illustrated in any figure), then that sacrificial substrate may be removed after the device layer 11 and the interposer layer 71 have been bonded to the handle layer 51 in figure 2f and before steps illustrated in figures 2g and 2h are performed. If, on the other hand, the other oxide layer 22 is present on top of the device layer 11 as figure 2f illustrates, then it is removed at the same time as layer 21 in figure 2h.

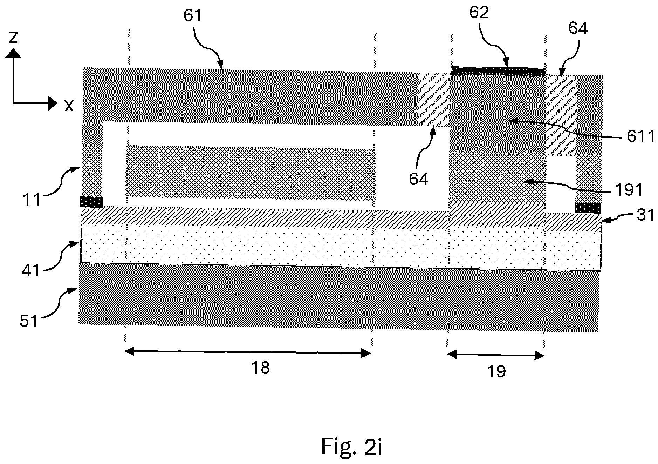

Finally, in figure 2i the cap layer 61 is bonded to the device layer 11 to seal the active parts of the device in an enclosure. The cap layer 61 comprises an electrical contact 62, which may for example be on the top surface of the cap layer 61 as figure 2i, but could alternatively be elsewhere in the cap. The vertical contact 611 in the cap layer 61 is aligned with the via region 191 in the z-direction. An electrical connection is thereby established from the polysilicon layer 31 to the electrical contact 62.

The layered stack may then be diced into individual chips. Although the schematic illustrations in figures 2a - 2i show the elements of just a single chip, thousands of similar chip elements may in practice be formed next to each other in the process described above. These chips may then be separated from each other when the cap layer 61 has been bonded to the device layer 11.

In a first additional embodiment, which may be combined with any other embodiment presented in this disclosure, the method may comprise, after the deposition of polysilicon layer 31 on the oxide layer 21 in figure 2d, the deposition of an additional polysilicon layer 32 over the layer 31. This is illustrated in figure 3a, where the additional polysilicon layer 32 is on top. The additional polysilicon layer 32 may be undoped. The electrical conductivity of the additional polysilicon layer 32 may be at least one order of magnitude less than the electrical conductivity of the doped polysilicon layer 31. The thickness of the additional polysilicon layer 32 in the z-direction may for example be 1 micron. The thickness of layer 32 may for example be at least twice the thickness of layer 31 (this relationship is not illustrated in figure 3a).

A second thermal oxidation process may then be performed to oxidize the additional polysilicon layer 32. This is illustrated in figure 3b, where an additional oxide layer 23 has been formed from the additional polysilicon layer 32. This additional oxide layer 23 is a silicon dioxide layer. Figure 3c shows the deposition of the insulating layer 41 as in figure 2e. All subsequent process steps from figures 2f - 2i may then be performed in the manner described above, with the additional oxide layer 23 located between the insulating layer 41 and polysilicon layer 31 (in locations where the polysilicon layer 31 is not present, the additional oxide layer 23 may be located between the insulating layer 41 and oxide layer 21). In other words, the additional oxide layer 23 becomes a part of the interposer layer 71 in this embodiment. The interposer layer 71 may consequently comprise an additional silicon dioxide layer 23 between the insulating layer 41 and the polysilicon layer 31.

In a second additional embodiment, which may be combined with any other embodiment presented in this disclosure, the microelectromechanical device may be configured to perform a second capacitive measurement between the mass element 111 and the cap layer 61. In other words, a second capacitive signal may be retrieved from the device, and the mass element may again function as one of the electrodes in this capacitive measurement. A second counterelectrode located on the cap, which may be called a cap electrode, forms the other electrode.

In this second additional embodiment the cap layer comprises a cap electrode, and the cap electrode faces and is adjacent to a second measurement region of the MEMS device layer, and the cap electrode is separated from the second measurement region of the MEMS device layer by a second gap.

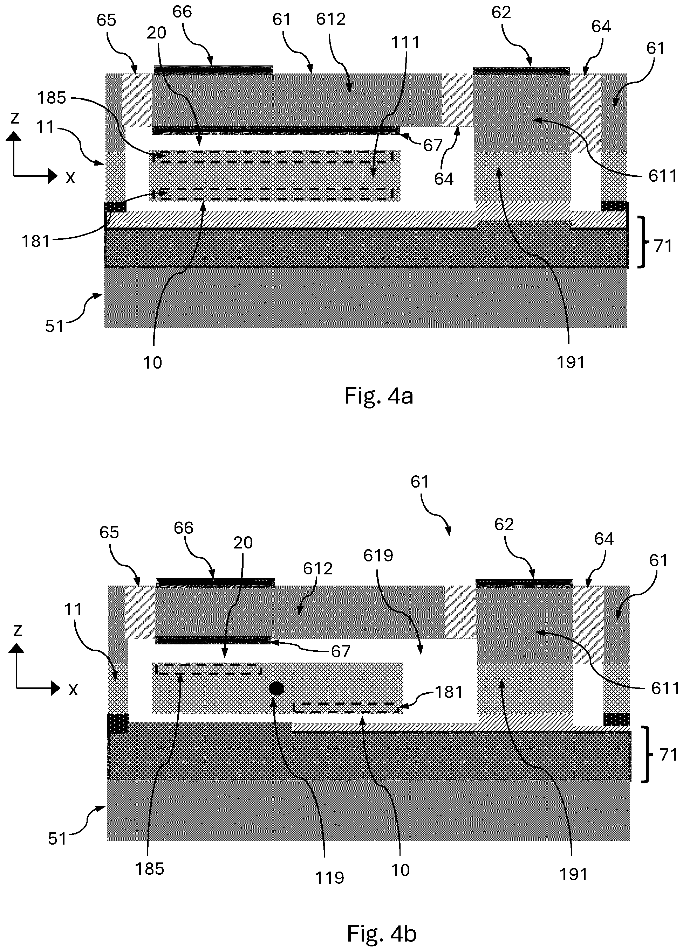

The second measurement region in the MEMS device layer 11 may overlap, or partially overlap, with the first measurement region 181. Figure 4a illustrates this alternative. The second measurement region is indicated with reference number 185, and it may be (but does not have to be) coextensive with the first measurement region 181 in the xy-plane, as figure 4a illustrates. A cap electrode 67 has been placed on the bottom of the cap layer 61. The cap electrode 67 is separated from the second measurement region 185 on mass element 111 by a second gap 20. The mass element 111 may in figure 4a undergo either linear or rotational out-of-plane motion.

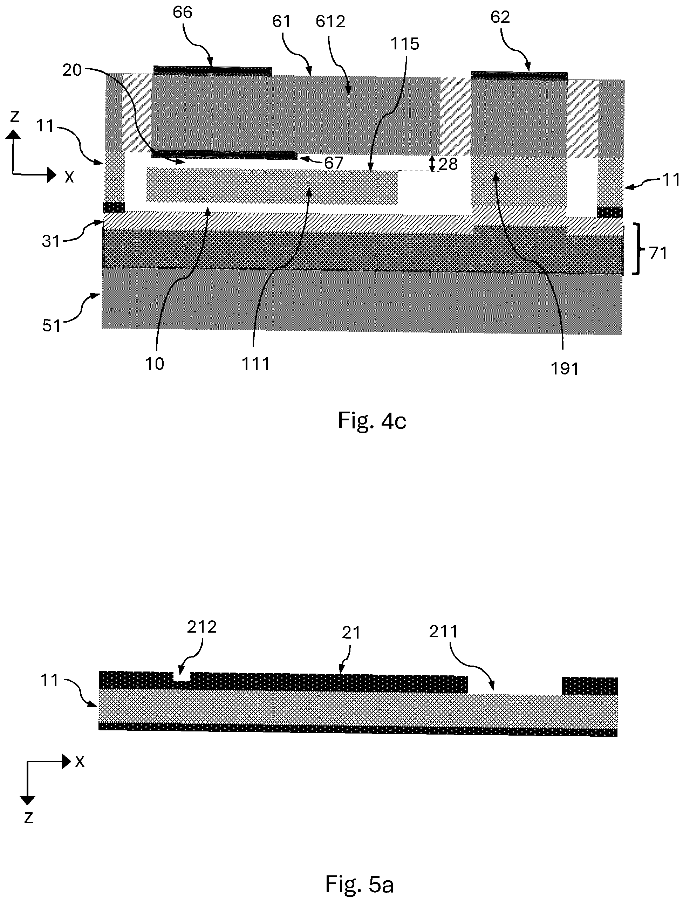

The cap electrode 67 may be electrically connected to a second external contact 66 in the cap layer 61. The first external contact 62 is electrically separated from the second external contact 66. The cap layer 61 may comprise a second vertical contact 612, which extends between the cap electrode 67 and the second external contact 66. The second vertical contact 612 may be electrically isolated from the first vertical electrical contact 611, and from other vertical electrical contacts which may be used to retrieve a signal from the mass element 111, by insulating regions in the cap layer 61, such as 64 and 65. These considerations apply also to figures 4b and 4c.

The benefit of using the same region of the mass element 111 as both the first (181) and second (185) measurement region (on opposite sides of the mass element in the z-direction) is that this facilitates a differential measurement. A capacitance measured across the first gap 10 may be labelled C1, and a capacitance measured across the second gap 20 may be labelled C2. When the first and second measurement regions are the same, movement of the mass element 111 in the positive z-direction (upward in figure 4a) decreases C1 and increases C2, while movement in the negative z-direction (downward) increases C1 and decreases C2. The differential capacitance DC = C1 - C2 will typically exhibit a more linear dependence on mass displacement than either of the two capacitances individually.

Figure 4b illustrates another option where the first (181) and second (185) measurement regions on the mass element 111 are on opposite sides of a rotation axis 119. The mass element rotates about the rotation axis 119. In this case both C1 and C2 increase when the mass element rotates clockwise, and they both decrease when the mass element rotates counterclockwise.

In both figures 4a - 4b, and also in preceding figures, the cap layer 61 comprises a cavity 619 above the mass element 111. This prevents the cap layer 61 from coming into direct contact with the mass element 111. However, it can in some applications be more convenient to form a recess on the top surface of the mass element 111 (that is, to make the mass element thinner in the z-direction). No cavity may then be needed in the cap layer 61.

The recessing of device layer 11 may for example be performed after the bonding step illustrated in figure 2f. If the device layer 11 is made thinner by chemical-mechanical polishing, then the recessing may follow the polishing.

The recessing can be carried out with many different etching methods. It may in some applications be particularly advantageous to perform the recessing in a local-oxidation-of-silicon (LOCOS) process. As explained in more detail below, this allows the height of the second gap 20 to be controlled very accurately.

Any of the structures illustrated in figures 4a - 4c could alternatively be utilized for applying a force to mass element 111 which moves the mass element in the z-direction. In other words, the electrodes above and below the mass element 111 could alternatively be used for actuating motion in the mass element. Alternatively, if the device is a gyroscope, they may be used for quadrature compensation.

The method for manufacturing the microelectromechanical device may therefore comprise providing a cap electrode and a second external contact in the cap layer, so that the cap electrode is connected to the second external contact, performing local-oxidation-of-silicon at least in the second measurement region on the second side of the MEMS device layer to recess the second side of the MEMS device layer to a recess depth in the second measurement region before bonding the cap layer to the second side of the MEMS device layer, and bonding the cap layer to the second side of the MEMS device layer so that the cap electrode faces and is adjacent to the second measurement region of the MEMS device layer.

Figure 4c illustrates a device where the mass element 111 has been recessed from the top side before the cap layer 61 was bonded to the device layer 11. The cap layer 61 does not in this case contain any cavity above the mass element 111. Instead, the top surface 115 of the mass element has been recessed (for example by LOCOS, or another etching process) to a recess depth 28. The recess depth corresponds to the vertical distance from the top surface of the device layer 11 to the top surface 115 of the mass element 111 after the recessing has been performed.

Recessing by LOCOS allows the recess depth 28 to be set with high accuracy. Furthermore, the vertical thickness of the cap electrode 67 may also be controlled with high accuracy if it is deposited with a suitable deposition process on the bottom surface of the cap layer 61. Consequently, the height of the second gap 20 in the z-direction may be set with high accuracy.

In any of the embodiments illustrated in figures 4a - 4c, the height of the first gap 10 in the z-direction may be substantially equal to the height of the second gap 20 in the z-direction.

In a third additional embodiment, which may be combined with any other embodiment presented in this disclosure, the interposer layer 71 may comprise a stopper bump which extends in the z-direction toward the MEMS device layer 11. Figures 5a - 5b illustrate this alternative. Figure 5a corresponds to figure 2c. However, in addition to the opening 211 (where the polysilicon layer 31 will eventually come into contact with device layer 31), the oxide layer 21 also comprises a partial opening 212. This partial opening forms a cavity in the oxide layer 21, but the partial opening does not extend all the way through the oxide layer 21 in the z-direction.

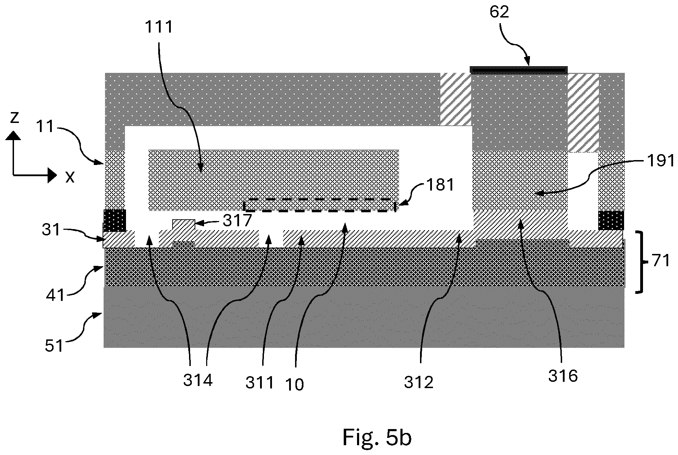

In the next steps of the manufacturing process, which are not separately illustrated but follow the scheme illustrated in figures 2d - 2i, the polysilicon layer will form a protrusion in the measurement region 181, which extends toward the device layer 11, but not all the way to the device layer. Figure 5b illustrates the protrusion in the polysilicon layer 31, which forms the stopper bump 317. The location of the stopper bump 317 is determined by the location of the partial opening 212 in figure 5a. The stopper bump is formed in the same manner as the part 316 of the polysilicon layer 31 which extends all the way to the via region 191 in the device layer 11, except that a stopper gap remains between the stopper bump 317 and the mass element 111. The height of this stopper gap is determined by the thickness of the oxide layer 21 beneath partial opening 212 in figure 5a.

Stopper bumps may optionally be separated from electrode structures, since one purpose of a stopper bump may be to stop the motion of a mass element before the capacitor is electrically short-circuited. Since the stopper bump does make contact with the mass element, the bump itself should in this case not come into direct contact with the electrode. Figure 5b illustrates openings 314 in polysilicon layer 31, which isolate the region of the polysilicon layer 31 where the stopper bump is located from the electrode region 311 and the interconnection region 312. Such openings in the polysilicon layer 314 may for example be formed between the steps illustrated in figures 2d - 2e. The microelectromechanical device may optionally also comprise a second stopper bump (not illustrated) on cap layer 61, which is adjacent to the mass element 111 and prevents the mass element from coming into contact with other parts of the cap layer 61.

Optionally, the method may also comprise perforating the MEMS device layer in the first measurement region before removing the insulating layer at least from the first measurement region of the MEMS device layer.

## Claims

1. A microelectromechanical device which comprises:
- a MEMS device layer which defines an xy-plane, wherein a z-direction is perpendicular to the xy-plane, wherein the MEMS device layer is made of silicon, and the MEMS device layer comprises a first measurement region and a via region, and the first measurement region is electrically separated from the via region,
- a handle layer, wherein the handle layer has a surface which faces toward the MEMS device layer,
- a cap layer, wherein the handle layer and cap layer are on opposite sides of the MEMS device layer,
and the microelectromechanical device also comprises an interposer layer between the handle layer and the MEMS device layer, and the interposer layer comprises an insulating layer on the surface of the handle layer and a polysilicon layer on the insulating layer, and
- the polysilicon layer comprises an electrode region which is adjacent to the first measurement region of the MEMS device layer, and the electrode region of the polysilicon layer is separated from the first measurement region of the MEMS device layer by a first gap, and
- the polysilicon layer also comprises an interconnection region which extends from the electrode region to the via region of the MEMS device layer, so that the electrode region of the polysilicon layer is in electrical contact with the via region of the MEMS device layer, and
- the via region of the MEMS device layer is electrically connected to a first external contact in the cap layer.

2. A microelectromechanical device according to claim 1, wherein the height of the first gap in the z-direction is in the range 1 - 3 micrometers.

3. A microelectromechanical device according to any of claims 1-2, wherein the cap layer comprises a cap electrode, and the cap electrode faces and is adjacent to a second measurement region in the MEMS device layer, and the cap electrode is separated from the second measurement region of the MEMS device layer by a second gap.

4. A microelectromechanical device according to claim 3, wherein the height of the first gap in the z-direction is substantially equal to the height of the second gap in the z-direction.

5. A microelectromechanical device according to any of claims 3-4, wherein the cap electrode is connected to a second external contact in the cap layer.

6. A microelectromechanical device according to any preceding claim, wherein the MEMS device layer is perforated in the z-direction.

7. A microelectromechanical device according to any preceding claim, wherein the interposer layer comprises a stopper bump which extends in the z-direction toward the MEMS device layer.

8. A microelectromechanical device according to any preceding claim, wherein the device is a gyroscope.

9. A microelectromechanical device according to any of claims 1-7, wherein the device is an accelerometer.

10. A microelectromechanical device according to any of claims 1-7, wherein the device is both a gyroscope and an accelerometer.

11. A method for manufacturing a microelectromechanical device, wherein the method comprises:
- providing a MEMS device layer, wherein the MEMS device layer is made of silicon, and the MEMS device layer comprises a first measurement region and a via region,
- providing a handle layer and a cap layer, wherein the cap layer comprises a first external contact,
- forming an oxide layer on a first side of the MEMS device layer, and forming an opening in the oxide layer in the via region of the MEMS device layer,
- depositing a polysilicon layer on the oxide layer at least in the first measurement region and the via region of the MEMS device layer, so that the polysilicon layer comes into contact with the MEMS device layer through the opening in the via region,
- forming an insulating layer on the polysilicon layer,
- bonding the handle layer to the insulating layer,
- removing the oxide layer at least from the first measurement region of the MEMS device layer,
- bonding the cap layer to a second side of the MEMS device layer so that the first external contact in the cap layer comes into electrical contact with the via region of the MEMS device layer, wherein the second side of the MEMS device layer is opposite to the first.

12. A method according to claim 11, wherein the thickness of the oxide layer in the z-direction is in the range 1 - 3 micrometers.

13. A method according to any of claims 11-12, wherein the handle layer is bonded to the insulating layer by fusion bonding.

14. A method according to any of claims 11-13, wherein the method also comprises:
- providing a cap electrode and a second external contact in the cap layer, so that the cap electrode is connected to the second external contact,
- performing local-oxidation-of-silicon at least in the second measurement region on the second side of the MEMS device layer to recess the second side of the MEMS device layer to a recess depth in the second measurement region before bonding the cap layer to the second side of the MEMS device layer, and
- bonding the cap layer to the second side of the MEMS device layer so that the cap electrode faces and is adjacent to the second measurement region of the MEMS device layer.

15. A method according to any of claims 11-14, wherein the method also comprises:
- perforating the MEMS device layer in the first measurement region before removing the insulating layer at least from the first measurement region of the MEMS device layer.
